# EUROPEAN PATENT APPLICATION

(11) **EP 3 185 245 A1**
(43) Date of publication of application: **28.06.2017**
(21) Application number: 15201949.3
(22) Date of filing: 22.12.2015
(51) Int. Cl.: G11C 11/16, H01L 43/00, H01L 43/10

(54) **ANTIFERROMAGNETIC MEMORY DEVICE**

(71) Applicant: Hitachi, Ltd., Tokyo 100-8280 (JP)
(72) Inventor: Wunderlich, Joerg, Cambridge, Cambridgeshire CB3 0HE (GB); Olejnik, Kamil, 162 53 Praha 6 (CZ); Jungwirth, Tomas, 162 53 Praha 6 (CZ); Novak, Vit, 162 53 Praha 6 (CZ); Wadley, Pete, Nottingham, NG7 2RD (GB)
(74) Representative: Piotrowicz, Pawel Jan Andrzej

(57) **Abstract**

An antiferromagnetic memory device is disclosed. The antiferromagnetic memory device comprises an antiferromagnetic region (24) and an easy axis (32) and first and second contacts (251, 252) which define a conductive path (33) in a first direction wherein a current flowing along the conductive path induces a 180° re-orientation of the magnetization of the antiferromagnetic region. The antiferromagnetic memory device is a two-terminal device.

## Description

### Field of the Invention

The present invention relates to an antiferromagnetic memory device.

### Background

The first generation of magnetic random access memories (MRAMs) based on the anisotropic magnetoresistance (AMR) relied on magnetic fields for both writing and reading the information in a uniaxial ferromagnet as described, for example, in J. M. Daughton: "Magnetoresistive memory technology", Thin Solid Films, volume 216, page 162 (1992). In these AMR-MRAMs, magnetization is reversed by Oersted fields. The Oersted field is also used to partially tilt magnetic moments during read-out so as to break the symmetry between the positive and negative magnetization states. Breaking symmetry in this way makes it possible to generate an AMR signal which is a fraction of one percent so as to allow detection of magnetization reversal in a ferromagnetic film. Without the tilt (that is, for magnetic moments that are reoriented by 180°) AMR would vanish.

In giant magnetoresistance (GMR) or tunnelling magnetoresistance (TMR) MRAMs (reference is made to C. Chappert, A. Fert and F. N. Van Dau: "The emergence of spin electronics in data storage", Nature Materials, volume 6, page 813 (2007)), the Oersted field is not used in readout. Instead, the GMR or TMR effect is exploited by interfacing with a first, so-called "free" ferromagnet in which magnetization can be reversed and which stores information. The information stored in the free ferromagnet can be read using a second, "fixed" ferromagnet in which alignment of magnetization is fixed. The non-relativistic GMR and TMR effects with high and low resistance states corresponding to the antiparallel and parallel orientations of the magnetizations of the free and fixed ferromagnets is based on spin-dependent transport between the two ferromagnets. In these ferromagnetic bilayer structures, non-relativistic spin-transfer torque effects generated by the spin-dependent transport between the two ferromagnets can be also used to remove magnetic fields from writing the free magnet and reference is made to D. C. Ralph and M. D. Stiles: "Spin transfer torques", Journal of Magnetism and Magnetic Materials, volume 320, page 1190 (2008).

Recently, it has been demonstrated that relativistic spin torques can provide a way of electrically-manipulating ferromagnets without transferring angular momentum between the information-storing ferromagnet and the reference ferromagnet and reference is made to I. M. Miron et al.: "Perpendicular switching of a single ferromagnetic layer induced by in-plane current injection", Nature, volume 476, page 189 (2011) and L. Liu et al.: "Spin Hall effect tunnelling spectroscopy", Science, volume 336, page 555 (2012). Since the relativistic spin-orbit interaction couples the momentum and the spin of an electron, it can lead to a range of effects when systems are brought out of equilibrium by applied electric fields. Non-equilibrium spin polarization phenomena may occur even in non-magnetic spin-orbit coupled conductors. Prime examples of these phenomena are the inverse spin galvanic effect (iSGE) and the spin Hall effect (SHE) which were experimentally discovered as companion effects, originally in GaAs-based non-magnetic semiconductor structures. Reference is made to Y. K. Kato, R. Myers, A. Gossard, and D. D. Awschalom: "Current-Induced Spin Polarization in Strained Semiconductors", Physical Review Letters, volume 93, page 176601 (2004), Y. K. Kato et al.: "Observation of the Spin Hall Effect in Semiconductors", Science, volume 306, page 1910 (2004), J. Wunderlich, B. Kaestner, J. Sinova, and T. Jungwirth: "Experimental discovery of the spin-Hall effect in Rashba spin-orbit coupled semiconductor systems", arXiv:cond-mat/0410295v1 (2004) and J. Wunderlich, B. Kaestner, J. Sinova, and T. Jungwirth: "Experimental Observation of the Spin-Hall Effect in a Two-Dimensional Spin-Orbit Coupled Semiconductor System", Physical Review Letters, volume 94, page 047204 (2005). In the inverse spin galvanic effect, a non-equilibrium spin-density of carriers is generated in spin-orbit coupled systems which lack inversion symmetry. In the SHE, an electrical current passing through a material with relativistic spin-orbit coupling can generate a transverse pure spin-current polarized perpendicular to the plane defined by the charge and spin-current.

Relativistic spin-torques acting in ferromagnets occur due to the iSGE and/or the SHE. In case of iSGE, a non-equilibrium spin-density is generated via the iSGE and the corresponding effective field induces the spin torque on the magnetization. Reference is made to B. Bernevig and O. Vafek: "Piezo-magnetoelectric effects in p-doped semiconductors", Physical Review B, volume 72, page 033203 (2005), A. Manchon and S. Zhang: "Theory of nonequilibrium intrinsic spin torque in a single nanomagnet", Physical Review B, volume 78, page 212405 (2008) and A. Chernyshov et al.: "Evidence for reversible control of magnetization in a ferromagnetic material by means of spin-orbit magnetic field", Nature Physics, volume 5, volume 656 (2009). Ferromagnetic semiconductor structures based on gallium arsenide provided initial experimental evidence of this phenomenon.

On the other hand, a spin-current generated via the SHE outside of the magnetic structure propagates from a spin-orbit coupled layer towards the interface with an adjacent ferromagnet where the spin angular momentum of the carriers can exert spin-torque on the magnetization.

As explained hereinbefore, GMR and TMR can be used to detect magnetisation reversal in ferromagnetic systems. In early MRAM applications, AMR, together with an externally applied magnetic field, was also used to distinguish remnant magnetic states with opposite sign.

In antiferromagnetic systems, AMR-effects in the ohmic and tunnelling regime were used to identify the reorientation of the magnetic moments. Since antiferromagnets are insensitive to moderate applied magnetic fields, an AMR reading scheme similar to that used for ferromagnets cannot be used for antiferromagnets.

The challenge is to find the counterpart reading scheme for the 180° magnetization reversal in antiferromagnetic structures which does not require a symmetry-breaking magnetic field, as in case of AMR read-out in ferromagnets, or a reference ferromagnet, as is required for GMR or TMR readout in ferromagnetic layer systems.

As explained hereinbefore, AMR effect without symmetry-breaking field is not suitable. Likewise, the recently-identified spin Hall magnetoresistance, (SHMR) which is described in H. Nakayama et al.: "Spin Hall Magnetoresistance Induced by a Nonequilibrium Proximity Effect", Physical Review Letters, volume 110, page 206601 (2013), is also not suitable. Both AMR and SMHR remain unchanged upon 180° magnetisation reversal. In spin Hall magnetoresistance (SHMR), a spin current generated by the SHE is either absorbed at the metal-ferromagnet interface when the SHE polarization is transverse to the magnetization or is reflected when the SHE polarization is collinear to the magnetization. The reflected spin current generates an additional voltage via the inverse SHE which renormalizes the resistance of the device. Therefore, SHMR, similar to AMR, is an even-in-magnetisation effect and, therefore, independent of the sign of the magnetization.

Apart from the even-in-magnetisation magnetoresistance effects, such as AMR and SHMR, there are also linear-in-magnetisation magnetoresistance effects which contribute to the linear magneto-resistance (LMR).

One contribution to the LMR is the linear Spin Hall magnetoresistance (LSMR) which, opposite to the SHMR, is a magneto-resistance effect which enables the sign of magnetization to be distinguished, as described in K. Olejnik, V. Novak, J. Wunderlich, and T. Jungwirth: "Electrical detection of magnetization reversal without auxiliary magnets", Physical Review B, volume 91, page 180402(R) (2015). Such electrical detection of magnetization reversal without auxiliary magnets is due to interfacial spin-scattering of spin-polarisation generated by the SHE at interface with an adjacent ferromagnet.

Additional contributions to the LMR originate from the iSGE which appear if the system has no inversion symmetry.

As will be described hereinafter, the inverse spin galvanic effect magnetoresistance (iSGMR) is the more relevant contribution for writing and reading 180° moment reversals in co-linear antiferromagnets with magnetic sub-lattices form inversion partners.

The iSGMR can originate from the inversion asymmetry of the bulk crystal and from the structural inversion asymmetry due to an interface or interfaces in layered systems.

The interfacial iSGMR due to a Rashba-like ISGE has the same symmetry as the LSMR generated by the SHE. The bulk iSGMR, due to the bulk inversion asymmetry, arises as a result of a lack of inversion symmetry of the crystal lattice. In case of co-linear antiferromagnets, the bulk iSGMR may appear even if the crystal lattice is inversion-symmetric but the two magnetic sub-lattices must then have inversion asymmetry. In this case, the two spin sublattices form "inversion partners" as described in J. Zelezny, H. Gao, K. Vyborny, J. Zemen, J. Masek, A. Manchon, J. Wunderlich, J. Sinova, and T. Jungwirth: "Relativistic Neel-order fields induced by electrical current in antiferromagnets", Physical Review Letters, volume 113,157201 (2014).

In case of a ferromagnetic GaMnAs epilayer, the bulk inverse spin-galvanic effect has a combined Rashba and Dresselhaus symmetry as described in D. Fang, H. Kurebayashi, J. Wunderlich, K. Vyborny, L. P. Zarbo, R. P. Campion, A. Casiraghi, B. L. Gallagher, T. Jungwirth, and A. J. Ferguson: "Spin-orbit-driven ferromagnetic resonance", Nature Nanotechnology, volume 6, page 413 (2011). The corresponding Rashba and Dresslhaus iSGMR contributions add up for the current applied along one of the [110] or [110] crystal axes and subtract for the other orthogonal current direction as described in K. Olejnik, V. Novak, J. Wunderlich, and T. Jungwirth: "Electrical detection of magnetization reversal without auxiliary magnets", Physical Review B, volume 91, page 180402(R) (2015).

In the case of co-linear antiferromagnets with two magnetic sublattices, antiferromagnetic Néel order is formed by two oppositely-polarized spin-sublattice magnetic moments. States which are reversed by 180° in uniaxial systems (which in ferromagnets are most favourable for retention) are commonly regarded as indistinguishable. For this reason, existing antiferromagnetic-based memory devices have employed 90° reorientation between two memory states in biaxial systems as described in X. Marti et al.: "Room-temperature antiferromagnetic memory resistor", Nature Materials, volume 13, page 367 (2014).

### Summary

According to a first aspect of the present invention there is provided an antiferromagnetic memory device. The antiferromagnetic memory device comprises an antiferromagnetic region having broken inversion symmetry and an easy axis. The antiferromagnetic memory device also comprises first and second contacts to the antiferromagnetic region which define a conductive path in a first direction in which, when current flows along the conductive path, spin polarization is generated collinearly in a second direction which is oriented along the easy axis or at an angle which is equal to or less than 90° from the easy axis. The angle may be less than 45°, less than 30° or less than 10°. For example, the current path direction (i.e. first direction) may be perpendicular to the second direction if the current-induced spin polarisation is due to the inverse spin galvanic effect with Rashba-symmetry or due to the spin Hall effect. The antiferromagnetic memory device is a two-terminal device, i.e. there are only two contacts to the antiferromagnetic region.

Thus, the same two contacts can be used to not only to program the device, but also to measure the resistance of the device, i.e. read the device using linear magneto-resistance generated by the inverse spin galvanic effect or by the spin Hall effect.

The antiferromagnetic region may comprise an antiferromagnetic material exhibiting inversion asymmetry of the spin-sublattices or be configured to exhibit inversion asymmetry of the spin-sublattices. For example, the antiferromagnetic region may comprise a synthetic antiferromagnet comprising first and second oppositely-polarised ferromagnetic regions and a non-magnetic coupling region interposed between and directly in contact with the ferromagnetic regions.

The antiferromagnetic region may be configured so as to exhibit structural inversion asymmetry. For example, this may be achieved by having a sufficiently thin layer of antiferromagnetic material (e.g. a thickness no more than a few monolayers). The layer of antiferromagnetic may be a layer in a multilayer (e.g. bilayer) structure so as to form at least one antiferromagnetic/non-antiferromagnetic interface. The structural inversion symmetry may be broken when the antiferromagnetic layer is sandwiched or embedded between two different materials, for instance between an underlying layer of platinum (Pt) and an overlaying layer of tantalum (Ta) or *vice versa.* In this case, the magnetic sublattices of the antiferromagnet do not need to exhibit inversion asymmetry. For example, a single layer of antiferromagnetic IrMn does not exhibit inversion asymmetry, but a trilayer stack comprising Pt/IrMn/Ta is structurally inversion asymmetric. The antiferromagnetic layer may have a thickness of between 0.5 and 10 nm, for example, 3 or 4 nm.

The antiferromagnetic region may comprise an antiferromagnetic material which exhibits inversion asymmetry. The inversion asymmetry relates to the magnetic sub-lattices of the antiferromagnet. For examples, in antiferromagnet CuMnAs, CuMnP and Mn₂Au the inversion asymmetries of the two magnetic sub-lattices are opposite so that the global crystal structure is inversion symmetric and the two magnetic sublattices form inversion partners.

The device may comprise a substrate having a principle surface and the antiferromagnetic region and the first and second contacts may be disposed directly and/or indirectly on the principle surface of the substrate. The antiferromagnetic region and the first and second contacts may be coplanar.

The antiferromagnetic region may comprise a layer of antiferromagnetic material having a thickness between 0.5 nm and 20 nm.

The antiferromagnetic region may have a length and/or width of no more than 20 nm.

The antiferromagnetic region may be thinner than the first and second contacts, for example, no more than half the thickness. The antiferromagnetic region may be narrower (i.e. laterally less wide) than the first and second contacts.

The device may comprise a multilayer structure comprising at least two layers and the multilayer structure comprises a layer of antiferromagnetic material providing the antiferromagnetic region. The multilayer stack may include at least one layer of non-antiferromagnetic material directly in contact with the layer of antiferromagnetic material. The non-antiferromagnetic material may be non-ferromagnetic. The multilayer structure may take the form of a multilayer stack upstanding from a substrate. The multilayer structure may be arranged laterally. The multilayer structure may be coaxial.

The multilayer structure may include a layer of first non-antiferromagnetic material and a layer of second non-antiferromagnetic material, and the antiferromagnetic material may be interposed between the first and second non-antiferromagnetic material layers and the antiferromagnetic material is directly in contact with the layers of first and second non-antiferromagnetic materials. The first and second non-antiferromagnetic materials may be the same or may be different. The first and/or second non-antiferromagnetic materials may be non-ferromagnetic.

The antiferromagnetic material may be a metal or metal alloy, such as iridium manganese (IrMn), platinum manganese (PtMn), iron manganese (FeMn), chromium (Cr) or iron rhodium (FeRh).

The antiferromagnetic material may be a semiconductor, such as manganese telluride (MnTe), iron antimonide (FeSb), copper iron sulphide (CuFeS₂), manganese silicon nitride (MnSiN₂) or lithium manganese arsenide (LiMnAs).

The antiferromagnetic material may be an insulator, such as nickel oxide (NiO), cobalt oxide (CoO) or thulium iron oxide (TmFeO₃).

The antiferromagnetic region may comprise a semimetal, such as copper manganese arsenide (CuMnAs) or copper manganese phosphide (CuMnP).

The first and/or second non-magnetic, non-antiferromagnetic material(s) may be a transition metal, preferably a heavy transition metal such as iridium (Ir), platinum (Pt) or palladium (Pd), or an alloy comprising a transition metal, preferably a heavy transition metal.

The first and/or second non-magnetic, non-antiferromagnetic material(s) may be a topological insulator, such as BiSbTeSe₂, or an electrical insulator.

The antiferromagnetic region may exhibit uniaxial magnetic anisotropy. The antiferromagnetic region may exhibit multiaxial magnetic anisotropy, for example, biaxial magnetic anisotropy. Thus, there may be more than one easy axis. The antiferromagnetic region may be under strain. Strain may be used to promote or isolate one easy axis. Thus, strain may be applied to a multiaxial antiferromagnetic region may be used to isolate an easy axis. Strain may be applied by depositing materials having different lattice constants or by using a stressor, such as a piezoelectric stressor.

The antiferromagnetic region may comprise a synthetic antiferromagnet comprising first and second oppositely-polarised ferromagnetic regions and a non-magnetic coupling region interposed between and directly in contact with the ferromagnetic regions. The regions may comprise layers. The first and second oppositely-polarised ferromagnetic regions may comprise, for example, cobalt (Co). The coupling region may comprise, for example, ruthenium (Ru). The thickness of coupling layer may be less than 1 nm.

According to a second aspect of the present invention there is provided apparatus comprising an antiferromagnetic memory device, a write circuit configured to apply a bias between the first and second contacts so as to drive a current having a sufficiently large current density to generate sufficiently large spin polarization to cause sublattice magnetization to reorient by 180° and a read circuit configured to apply a bias between the first and second contacts so as determine resistance of the antiferromagnetic region.

The apparatus may comprise a refrigerator, for example, to cool the antiferromagnetic memory device below room temperature, e.g. to 77 K.

The apparatus may comprise a heater, for example, to heat the antiferromagnetic memory device above room temperature, e.g. to 400 K, to facilitate current-induced writing. Heating may be realised by current induced Joule heating.

According to a third aspect of the present invention there is provided memory comprising an array of memory cells, each memory cell including an antiferromagnetic memory device.

According to a fourth aspect of the present invention there is a method of operating an antiferromagnetic memory device. The method comprises programming the device by driving a current along the conductive path having a sufficiently large current density that so as to generate sufficiently large spin polarization so as to cause sublattice magnetization (i.e. magnetic moments in a sublattice) in the antiferromagnetic region to reorient by 180°.

The write current density may be at least 10⁵ or 10⁶ Acm⁻². The current density may be no more than 10⁸ Acm⁻² or no more than 10⁹ Acm⁻².

The method may comprise reading the device by driving a current along the conductive path having a current density that does not cause sublattice magnetic moments in the antiferromagnetic region to reorient by 180°.

The read current density may be no more than 10⁵Acm⁻².

The write and/or read pulses may have duration(s) of at least 1 ps, at least 10 ps or at least 100 ps. The write and/or read pulses may have duration(s) no more than 1 ns or no more than 10 ns.

### Brief Description of the Drawings

Certain embodiments of the present invention will now be described, by way of example, with reference to the accompanying drawings, in which:
Figure 1 is a schematic diagram illustrating a linear spin Hall magnetoresistance effect;
Figure 2 is a schematic diagram of a device and circuitry for measuring a linear magnetoresistance effect (LMR) with contributions from LSMR and iSGMR;
Figure 3 are plots of longitudinal resistance measurements at 130 K in a (Ga,Mn)As bilayer device as a function of external magnetic field;
Figure 4 is a plot of difference in resistance for states for opposite magnetizations as a function of the applied current;
Figure 5 is a plot of longitudinal resistance as a function of the applied current at 130 K as current is swept up and down;
Figure 6 shows measured resistance values during read/write memory operation of the device shown in Figure 2;
Figure 7a illustrates electrical writing of an antiferromagnet;
Figure 7b illustrates electrical reading of an antiferromagnet in a first current direction;
Figure 7c illustrates electrical reading of an antiferromagnet in a second, opposite current direction;
Figure 8 is a perspective view of an antiferromagnetic memory device;
Figure 9 is a schematic diagram of the crystal structure of an antiferromagnetic material which exhibits local bulk inversion asymmetry of the antiferromagnetic spin sublattices and which can be used in the antiferromagnetic region of the memory device shown in Figure 8;
Figure 10 is a plan view of an antiferromagnetic region of the antiferromagnetic memory device shown in Figure 8;
Figure 11 shows circuitry which can be used to program and read the antiferromagnetic memory device shown in Figure 8;
Figures 12a and 12b illustrate biases used for programming the antiferromagnetic memory device shown in Figure 8;
Figures 13a and 13b illustrate programming the antiferromagnetic memory device shown in Figure 8;
Figure 14 illustrates bias used for reading the antiferromagnetic memory device shown in Figure 8;
Figure 15 is a plan view of another antiferromagnetic memory device;
Figure 16 illustrates a bilayer structure comprising a layer of antiferromagnetic material which exhibits structural inversion asymmetry;
Figure 17 illustrates a trilayer structure comprising a layer of antiferromagnetic material which exhibits structural inversion asymmetry;
Figures 18a and 18 illustrate synthetic antiferromagnetic layer structures with out-of-plane magnetic anisotropy and in-plane magnetic anisotropy;
Figures 19a and 19b illustrate synthetic antiferromagnetic layer structures with repeated units based on the structures shown in Figure 18a and 18b respectively;
Figure 20 is a schematic block diagram of memory including an array of memory cells, each cell including an antiferromagnetic memory device; and
Figure 21 illustrates a cell used in the memory shown in Figure 19.

### Detailed Description of Certain Embodiments

### Ferromagnetic memory device

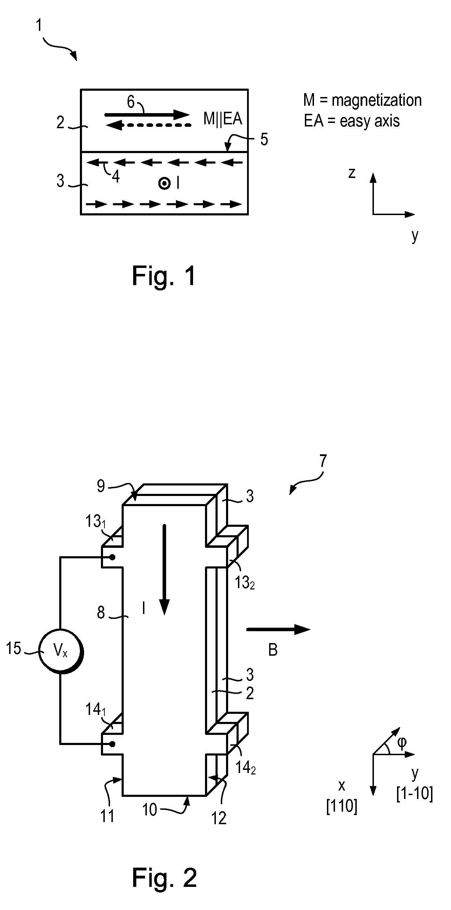

Methods of writing and reading a ferromagnetic memory device involving a 180 degree reversal of magnetization will be described with reference to Figures 1 and 2 which is useful for understanding the invention.

Referring to Figure 1, a ferromagnetic layer structure 1 for exhibiting a linear magnetoresistance (LMR) in form of the linear spin Hall magnetoresistance (LSMR) is shown. The layer structure 1 is based on manganese (Mn) doped gallium arsenide (GaAs). In such relativistic structures, the linear magnetoresistance can occur with maximum and minimum resistance values corresponding to the opposite magnetization directions and current polarities. Minimum and maximum resistance values corresponding to positive current polarity become Maximum and minimum resistance values for negative current polarity.

The layer structure 1 comprises a ferromagnetic layer 2 in the form of an epitaxial layer of Ga_{0.91}Mn_{0.09}As having a thickness of 10 nm and a Curie temperature T_{c1} = 155 K grown on top of a paramagnetic layer 3 in the form of a layer of Ga_{0.97}Mn_{0.03}As having a thickness of 10 nm and which remains paramagnetic down to T_{c2} = 95 K. The paramagnetic layer 3 has a similar conductivity to the ferromagnetic layer 2 and a sizable spin Hall effect (SHE) angle is expected.

For a given in-plane current polarity, the SHE generates a fixed in-plane, perpendicular-to-current spin-polarization 4 in the paramagnetic layer 3 at the interface 5 with the ferromagnetic GaMnAs. When the axis of the in-plane magnetization 6 of the ferromagnet is also transverse to the current, then switching the sign of the magnetization results in the linear spin Hall magnetoresistance.

This can be seen as being analogous to a ferromagnetic bilayer structure operated in the current-in-plane giant magnetoresistance geometry except that the fixed reference ferromagnet is replaced by a paramagnetic spin Hall effect polarizer. Since spin Hall angles (or more generally, the charge to spin conversion efficiency) in strongly spin-orbit coupled systems are of the order of 1 to 10%, the linear spin Hall magnetoresistance can potentially have larger amplitudes than the quadratic-in-SHE angle magnetoresistance.

Referring to Figure 2, a device 7 in the form of a Hall bar is shown. The Hall bar 7 comprises an elongate bi-layer channel 8 running between first and second ends 9, 10 and having first and second opposite sides 11, 12. The Hall bar 7 comprises a first pair of contacts 13₁,13₂ disposed on opposite sides of the channel 8 and a second pair of contacts 14₁,14₂ disposed on opposite sides of the channel 8 longitudinally spaced from the first pair of contacts 13₁,13₂. The Hall bar 7 has a length, 1, of 10 µm and a width, w, of 2 µm. The Hall bar 7 is orientated along the magnetic hard axis, i.e. [110], of the ferromagnetic Ga_{0.91}Mno_{.09}As film 2. The device 7 is cooled in cryostat to 130 K.

A current, I, is driven along the channel 8 using a bias source (not shown). A longitudinal voltage, Vₓ, is measured between a pair of longitudinally-spaced contacts 13₁, 14₁ on one side of the channel 8 using a first voltage meter 15.

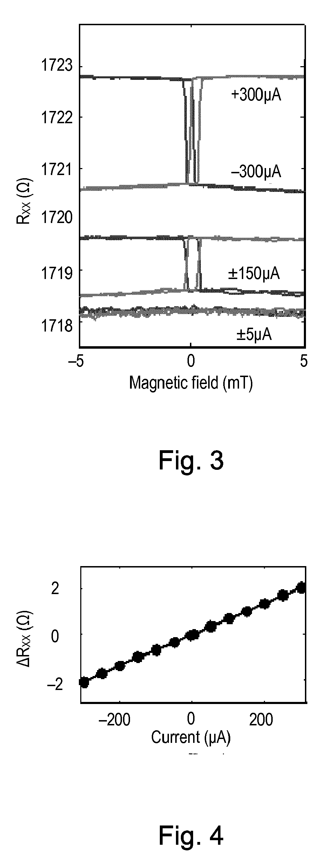

Figures 3 and 4 are plots of magnetoresistance at 130 K.

Referring to Figure 3, for a probe current of amplitude 5 µA (corresponding to current density of 1.25×10⁴ Acm⁻²), a negligible change in the longitudinal resistance Rₓₓ = Vₓ/I is observed for a magnetic field swept along the [1-10] easy-axis. In Figure 2, longitudinal resistances are scaled by the Hall bar aspect ratio.

Referring still to Figure 3, for probe currents of 150 and 300 µA, a magnetoresistance signal which increases with increasing current is observed and is an odd function when reversing magnetization by 180°. A jump in the hysteretic value Rₓₓ and a change in sign occurs at 0.2 mT (which is the easy-axis coercive field), when reversing the field sweep direction or the polarity of the probe current. Rₓₓ increases with increasing probe current.

Referring to Figure 4, the difference between resistance states for opposite magnetizations, set by sweeping the magnetic field from negative or positive values to the zero field, is shown as a function of current. The difference increases linearly with the applied probe current and changes sign for the opposite current polarity.

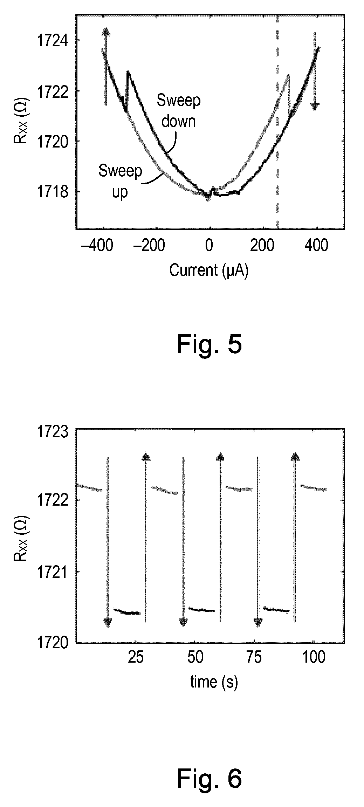

Referring to Figure 5, the coercive field in the ferromagnetic Ga_{0.91}Mn_{0.09}As film is sufficiently low that instead of applying the magnetic field externally, the magnetization can be switched by the current driven through the Hall bar 7. This is demonstrated in Figure 5.

The estimate value of Oersted field generated in the Hall bar 7 is sufficient to explain the observed switching. The relativistic ISGE- or SHE-induced fields can have the same symmetry and can contribute to the switching as well. The observed quadratic dependence of Rₓₓ on the applied current due to the Joule heating is accompanied by hysteretic jumps corresponding to the LMR under magnetization reversal.

Figure 6 illustrates all-electrical read/write memory functionality of the device 7.

Referring to Figures 5 and 6, the measurements of the memory state are performed in 10 s intervals with the reading current of ±250 µA. Setting current pulses of length 0.5 s and amplitude ±400 µA are applied to reverse the magnetization back and forth by 180°. It is emphasized that the Oersted magnetic field is aligned with the easy-axis of the ferromagnet and, as seen from Figures 5 and 6, magnetic fields produce no sizable magnetoresistance outside the switching events and, therefore, do not facilitate the read-out functionality. Instead the mechanism is attributable to linear spin Hall magnetoresistance.

The present invention is based, at least in part, on the insight that linear magnetoresistance originating both from the SHE and from the iSGE can enable 180° reversal read-out in an antiferromagnetic memory device.

Considering first the iSGE case:
In antiferromagnets whose spin sublattices form inversion partners, the iSGE can generate local non-equilibrium spin polarization whose sign alternates between the spin-sublattices. The sense of this alternating non-equilibrium spin-polarization is independent of the antiferromagnetic Néel vector and only depends on the direction of the applied current.

The corresponding staggered field when pointing collinear to the Néel vector or when pointing to an angle equal to or less than 90° to the Néel vector can reverse the magnetic moment orientation of the antiferromagnetic sublattices with the same efficiency as the non-relativistic spin transfer torque reverses the magnetization orientation of ferromagnets. Accordingly, the alternating non-equilibrium staggered spin polarization due to iSGE can be aligned first, for example, parallel with the staggered antiferromagnetic sublattice magnetizations.

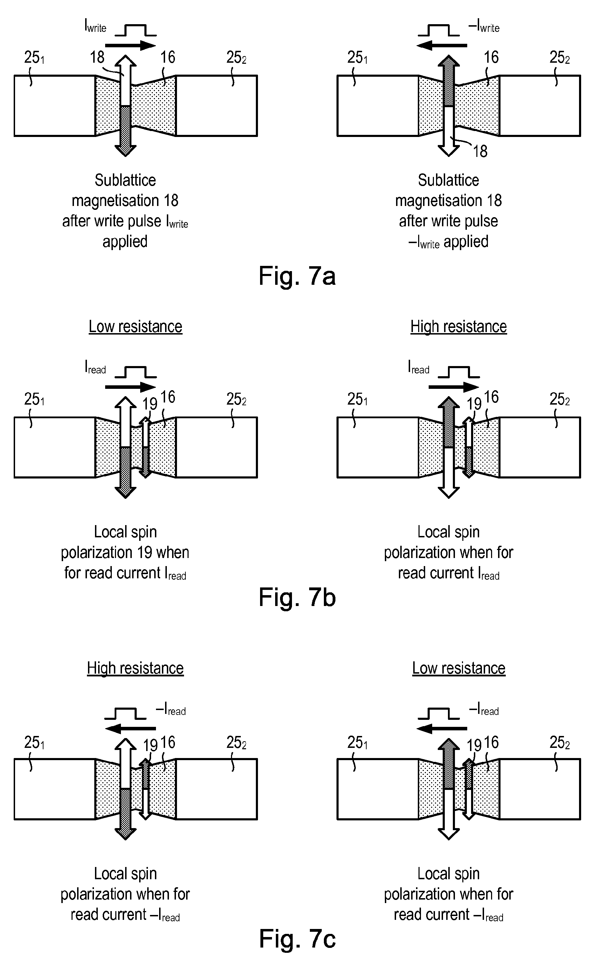

Referring to Figure 7a, for an antiferromagnet 16 interposed between two leads 171, 172, a fixed write current pulse I_{write} oriented transverse to the sub-lattice magnetisation 18 triggers the 180°-reversal of the antiferromagnetic Néel vector. Applying the write current with opposite polarity switches back by 180° the antiferromagnetic Néel vector to its original orientation.

Referring to Figures 7b and 7c, a read current of smaller amplitude I_{read} is applied along the same axis than the write current pulses were applied. Depending on the relative orientation between local sublattice moment orientation and the read current induced polarisation 19, the device as a high or low resistance.

Considering next the SHE case:
The active part of the device contains a bilayer where SHE generated spin current is injected into the antiferromagnet. If the spin-life time of the injected spins is longer than the spin precession time around the exchange field, a locally staggered spin polarisation can be generated. Therefore, switching of the Néel vector can be also achieved by spin-injection of a SHE generated spin-current into an antiferromagnet. As described above, a read current of smaller magnitude than the write current pulse is used to read-out the Neel-vector orientation, **L = M_{A} - M_{B}.**

### Antiferromagnetic memory device

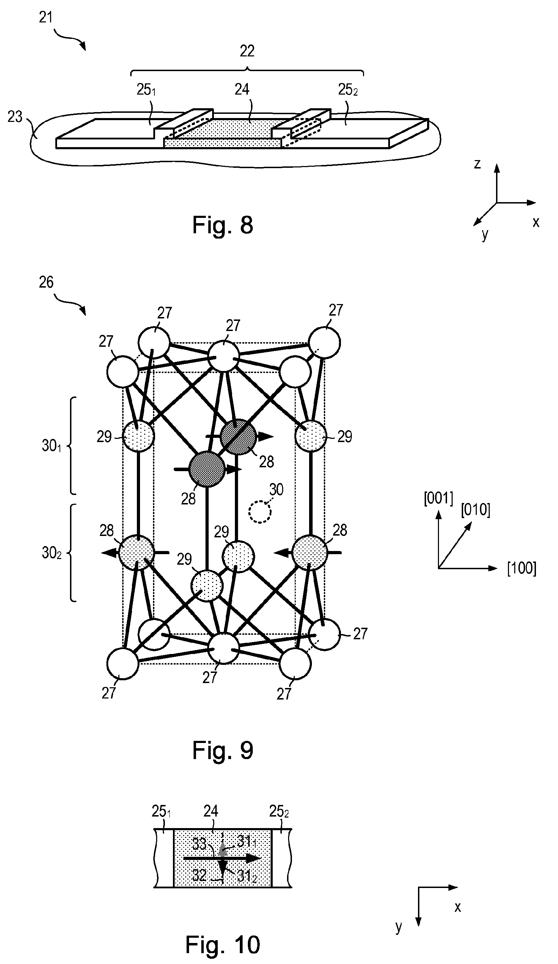

Referring to Figure 8, an antiferromagnetic memory device 21 is shown. The device 21 takes the form of a flat, linear, two-terminal structure 22 supported on an insulating substrate 23.

The structure 22 includes a planar antiferromagnetic region 24 (herein also referred to simply as an "antiferromagnet") running between first and second laterally-spaced, non-ferromagnetic conductive arms 251, 252.

Referring to Figure 9, the antiferromagnetic region 24 comprises tetragonal-phase copper manganese arsenic (CuMnAs) having a lattice 26 comprising atoms of copper 27, manganese 28 and arsenic 29. The antiferromagnetic region 24 may comprise copper manganese phosphide (CuMnP) having the same lattice structure. The lattice 26 has inversion symmetry having a centre of inversion which lies at an interstitial position 30. The manganese atoms 28 form two sublattices 301, 302 whose local environments has broken inversion symmetry and which form inversion partners.

The inverse spin galvanic mechanisms generate locally non-equilibrium spin polarizations of opposite signs on the inversion-partner sublattices 301, 302. For these staggered fields to couple strongly to the Néel order, the inversion-partner sublattices 301, 302 coincide with the two spin-sublattices A, B of the antiferromagnetic ground-states. The resulting spin-sublattice torques have the form d**M**_{A,B}/dt - **M**_{A,B} × **p**_{A,B} (where **M** is magnetization and **p** is the electrically-injected carrier spin-polarization) where the effective field proportional to p_{A} = -p_{B} acting on the spin-sublattice magnetizations alternates in sign between the two sublattices 301, 302. At the onset of the writing current, thermal fluctuation of the individual magnetic moments enable non-zero torques on the sublattice.

Other antiferromagnetic materials which exhibit broken inversion symmetry of the magnetic sublattices can be used, such as manganese-2 gold (Mn₂Au).

Alternatively, inversion symmetry can be broken structurally by making a layer of antiferromagnetic material sufficiently thin, for example a few monolayers thick and combining the antiferromagnetic layer in a bilayer (or multilayer) with structural inversion asymmetry.

Referring also to Figure 10, the spin sublattices 301, 302 have respective magnetic moments 311, 322 which are orientated in opposite directions along an easy axis 32. The easy axis 32 is orientated perpendicularly to a current path 33 between the first and second contacts 251, 252.

As will be explained in more detail later, the antiferromagnet 24 can be a uniaxial antiferromagnet having a single easy axis 32 or a multiaxial (e.g. biaxial) antiferromagnet which employs only one of the easy axes. In some cases, strain may be used to help promote or isolate an easy axis. For example, a piezoelectric stressor may be used, such as that described in EP 2 541554 A1.

The linear magnetoresistance is used to facilitate 180° reversal read-out of the antiferromagnetic region 24. As explained earlier, the inverse spin galvanic effect can generate local non-equilibrium spin polarization whose sign alternates between the spin-sublattices. The sense of this alternating non-equilibrium spin-polarization is independent of the antiferromagnetic Néel vector and only depends on the direction of the applied current. The corresponding staggered field when pointing collinear to the Néel vector or when pointing to an angle equal to or less than 90° to the Néel vector can reverse the antiferromagnet with the same efficiency as the non-relativistic spin torque reversal of the magnetization in ferromagnets.

The 180° reorientation of the magnetic moments in the antiferromagnetic regions may happen by domain wall propagation within the antiferromagnetic region.

The antiferromagnetic region 24 has a length, 1, a width, w, and a thickness, t. The thickness, t, may be in the range 0.5 nm to 100 nm, although preferably the thickness is no more than 20 nm, more preferably no more than 10 nm and still more preferably no more than 5 nm. The length, 1, and width, w, may be no more than 100 nm, no more than 50 nm or no more than 20 nm. The dimensions may be chosen so as to increase the current density in the antiferromagnetic region 24 compared to that of the leads.

The substrate 23 comprises gallium phosphide (GaP) and so CuMnAs can be grown epitaxially on gallium phosphide. The conductive arms 251, 252 comprise copper (Cu), aluminium (Al), gold (Au) or other suitable metal or doped semiconductor material. A protective layer (not shown) of a tantalum or other suitable metal or insulating material may be used to coat the antiferromagnetic region or the multilayer with the antiferromagnetic film(s) of the device.

The antiferromagnetic memory device 21 may be fabricated by a depositing (for example, by epitaxial growth, such as molecular beam epitaxy or sputtering) a layer (not shown) of antiferromagnetic material and patterning the deposited layer (not shown) using election-beam or photolithography to form a mask (not shown) and dry etching unwanted regions of the deposited layer to form the aniferomagnetic region 24 and then depositing (for example by sputtering or evaporation) a layer (not shown) of the conductive material and patterning the layer in a similar way to form the conductive arms 281, 282. The order of deposition may be reversed.

Referring to Figure 10, a circuit 41 used for programming and reading the device 21 is shown. The circuit 41 comprises a current source 42 for driving current through the antiferromagnet 24 in first and second opposite directions 43, 44 and a voltmeter 45 coupled to the conductive leads 281, 282.

The circuit 41 may include an on-chip heater (not shown) for example in the form a wire to heat the antiferromagnetic memory device above room temperature, e.g. to 400 K, to facilitate current-induced writing.

In some examples, a refrigerator in the form of a cryostat may be used.

### Writing and reading

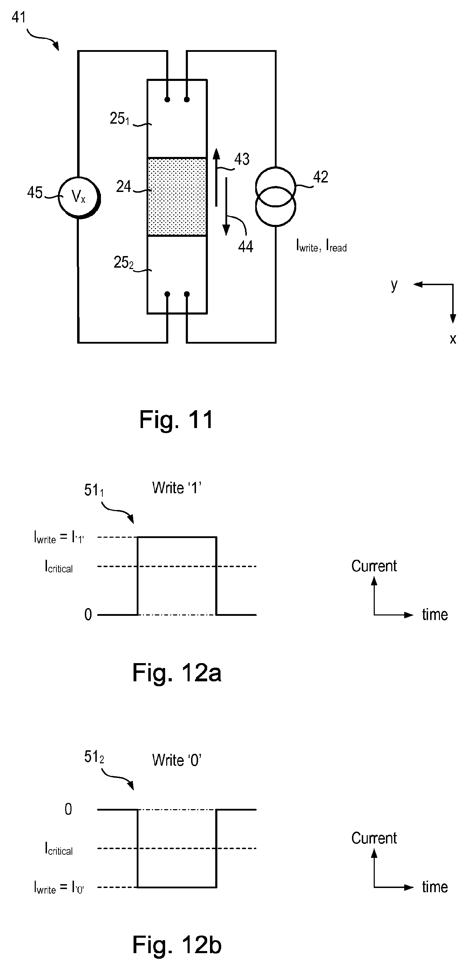

Referring to Figures 11a and 12a, to program a logical '1', a pulse 51₁ of current is passed in the first direction 43 through the antiferromagnetic region 24. The current density is sufficiently high (for example 10⁵ to 10⁹ Acm⁻²) to induce a staggered inverse spin galvanic effect field to couple to the magnetic moments 31₁, 31₂ and so cause tilting and eventual reorienting (i.e. 180° reversal) of magnetic moments 31₁, 31₂ four suitably orientated magnetic moments 31₁, 31₂. Thus, if the device 21 is in statue 'o', then the pulse 51₁ will reverse the magnetic moments 31₁, 31₂ and so change the state of the device 21 to '1'. If, however, the device 21 is already in a state '1', then the pulse does not change the state of the device 21.

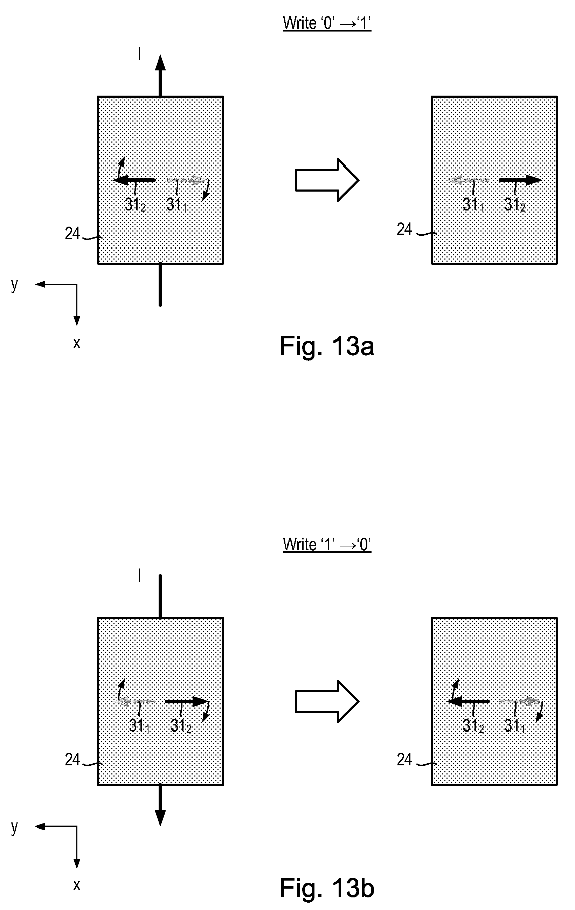

Referring to Figures 12a and 13a, to program a logical 'o', a pulse 51₂ of current is passed in the second direction 44 through the antiferromagnetic region 24. The current density is sufficiently high (for example 10⁵ to 10⁹ Acm⁻²) so as to exceed a critical current, I_{critial}, so as to induce a staggered inverse spin galvanic effect field to couple to the magnetic moments 31₁, 31₂ and so cause reorienting (i.e. 180° reversal) of magnetic moments 31₁, 31₂ for suitably orientated magnetic moments 31₁, 31₂. Thus, if the device 21 is in state '1', then the pulse 51₂ will reverse the magnetic moments 31₁, 31₂ and so change the state of the device 21 to 'o'. If, however, the device 21 is already in a state 'o', then the pulse does not change the state of the device 21.

Switching takes place when the local polarisation is anti-parallel to the local moment orientation. Switching does not take place when they are parallel. This is because when the system is in the latter state, it is in an energetic minimum. The energy of the system is higher if polarisation and moment are antiparallel.

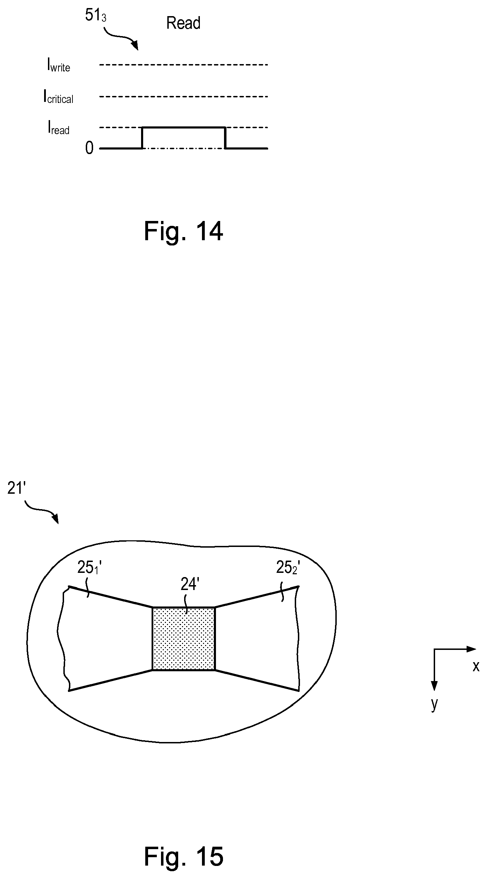

Referring to Figure 14, to read the state of the device, a pulse 513 of current is passed in the either the first or second direction 43, 44 through the antiferromagnetic region 24. The current density does not exceed the critical current, I_{critial}. The two states have different magnetoresistances and, thus, the state of the device can be determined.

Pulse times (write or read) can lie in a range between 1 ps to 10 ns or more.

### Alternative device geometry

Referring to Figure 15, another antiferromagnetic memory device 21' is shown.

The device 21' is similar to the device 21 shown in Figure 8. In this device 21', however, the antiferromagnetic region 24' is narrower and, optionally, thinner than the contacts 251, 252 such that the device takes a "bow-tie" appearance in plan view.

### Multi-layer stacks

As explained earlier, an antiferromagnet may exhibit magnetic sub-lattice inversion asymmetry by virtue of bulk inversion asymmetry, that is, due to the lattice structure of the material. However, an antiferromagnet may exhibit inversion asymmetry, even though it exhibits bulk invention symmetry, as a result of interface(s) with underlying and/or overlying non-antiferromagnetic layers.

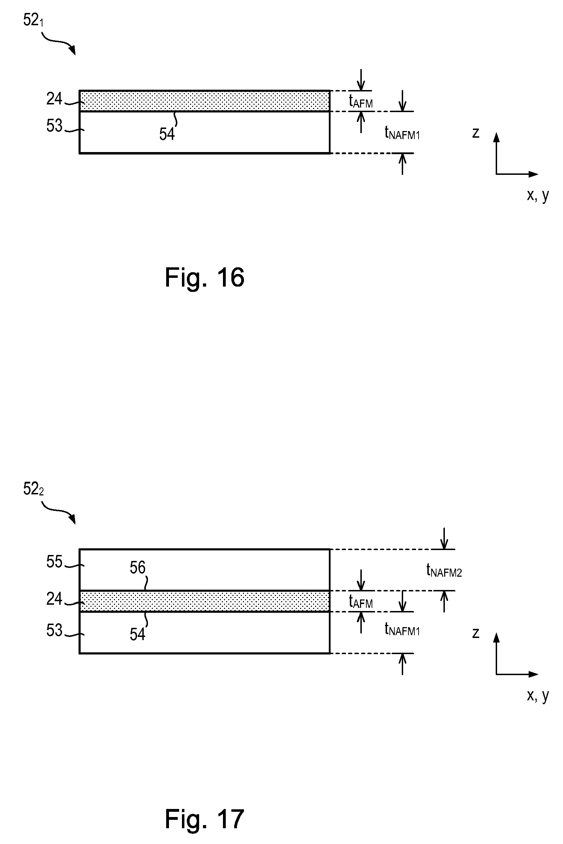

Referring to Figure 16, a first multilayer structure 521 is shown. The first multilayer structure 521 takes the form of a bi-layer comprising a layer 24 of antiferromagnetic material and an underlying layer 53 of non-magnetic, non-antiferromagnetic material thereby forming an interface 54.

The antiferromagnetic material may comprise an antiferromagnetic material which exhibits bulk invention symmetry, such as iridium manganese (IrMn).

The antiferromagnetic region may comprise an antiferromagnetic metal or metal alloy such as iridium manganese (IrMn), platinum manganese (PtMn), iron manganese (FeMn), chromium (Cr) or iron rhodium (FeRh).

The antiferromagnetic region may comprise an antiferromagnetic semiconductors such as manganese telluride (MnTe), iron antimonite (FeSb), copper iron sulphite (CuFeS₂), manganese silicon nitride (MnSiN₂) and lithium manganese nitride (LiMnAs).

The antiferromagnetic region of the multilayer stack may comprise an antiferromagnetic insulator such as nickel oxide (NiO), cobalt oxide (CoO) and thulium iron oxide (TmFeO₃)

The antiferromagnetic region comprises semimetals such as copper manganese arsenide (CuMnAs) or copper manganese phosphide (CuMnP).

The layer 24 of antiferromagnetic material has a thickness t_{AFM}. The thickness t_{AFM} may lie in the range of 0.5 nm to 10 nm. For thin antiferromagnetic films, the Néel temperature T_{N} can vary as a function of thickness and so the thickness t_{AFM} is preferably chosen to increase the Néel temperature T_{N}, more preferably, chosen to increase the Néel temperature T_{N} above room temperature. For example, for IrMn, may have a thickness of 3 or 4 nm.

The non-magnetic, non-antiferromagnetic material may comprise a heavy transition metal, such as iridium (Ir), platinum (Pt) or palladium (Pd), or an alloy including at least one heavy transition metal. The non-magnetic, non-antiferromagnetic material may comprise a topological insulator.

The non-magnetic, non-antiferromagnetic material may comprise an oxide such as aluminium oxide (AlOₓ, Al₂O₃), magnesium oxide (MgO) or a nitride, such as silicon nitride (Si₃N₄).

The layer 54 of non-antiferromagnetic material has a thickness t_{NAFM1}. The thickness t_{NAFM1} may be of the order of few nanometres. The thickness is thicker than the spin diffusion length in the non-antiferromagnetic material layer 54 so as to enable efficient generation of SHE spin current.

Referring to Figure 17, a second multilayer structure 521 is shown. The first multilayer structure 522 takes the form of a tri-layer comprising a layer 24 of antiferromagnetic material, an underlying layer 52 of first non-magnetic, non-antiferromagnetic material defining a first, lower interface 54 and an overlying layer 55 of a second non-magnetic, non-antiferromagnetic material defining a second, upper interface 56.

The antiferromagnetic material may comprise an antiferromagnetic material which exhibits bulk invention symmetry, such as iridium manganese (IrMn).

The layer 24 of antiferromagnetic material has a thickness t_{AFM}. The thickness t_{AFM} may lie in the range of 0.5 nm to 10 nm. The thickness t_{AFM} is preferably chosen to increase the Néel temperature, T_{N}, more preferably, chosen to increase the Néel temperature T_{N} above room temperature. For example, for IrMn, may have a thickness of 3 or 4 nm.

As with the first multilayer structure 52₁, in the second multilayer structure 52₂, the non-magnetic, non-antiferromagnetic materials may comprise a heavy transition metal, such as iridium (Ir), platinum (Pt) or palladium (Pd), or an alloy including at least one heavy transition metal.

As with the first multilayer structure 52₁, in the second multilayer structure 52₂, the non-magnetic, non-antiferromagnetic material may comprise a topological insulator.

Preferably, the first and second non-antiferromagnetic materials comprise complementary materials having opposite SHE angles. Since there are constructive contributions to spin polarization from both upper and lower interfaces 54, 56, the use of complementary materials can add-up to a stronger spin polarisation in the antiferromagnetic region. For example, the first and second non-antiferromagnetic materials may comprise platinum and tantalum respectively.

Each layer 52, 55 of the non-antiferromagnetic material has a respective thickness t_{NAFM1}, t_{NAFM2}. Each thickness t_{NAFM1}, t_{NAFM2} may be of the order of few nanometres. As explained earlier, the thickness is of the order of the spin diffusion length in the non-antiferromagnetic material layer so as to enable efficient generation of SHE spin current.

The layer structures 52₁, 52₂ are supported on the substrate 23 (Figure 8) and can be fabricated in substantially similar way to that hereinbefore described.

### Synthetic antiferromagnet

The antiferromagnetic region used in the antiferromagnetic memory device may take the form of a synthetic antiferromagnet. The synthetic antiferromagnetic region may have underlying and/or overlying non-antiferromagnetic layers for breaking inversion symmetry locally at the antiferromagnetically-coupled ferromagnetic regions.

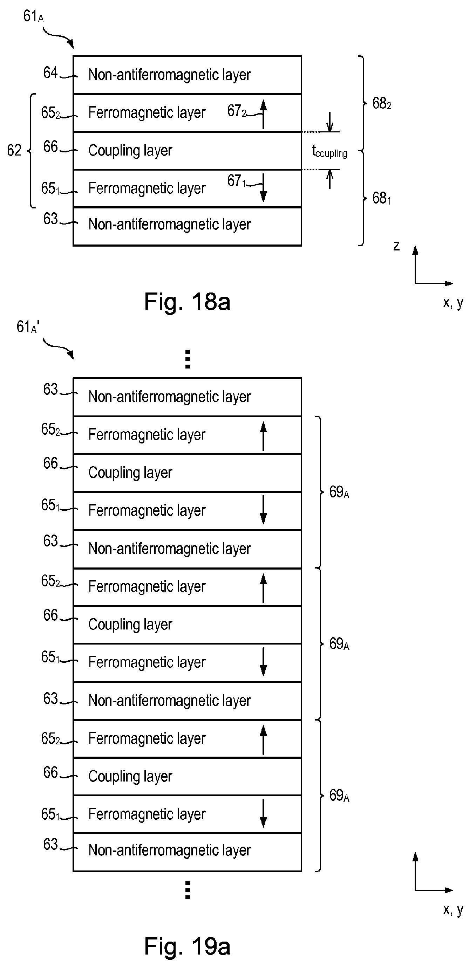

Referring to Figure 18a, a first layer structure 61A is shown which comprise a synthetic antiferromagnet 62 sandwiched between optional non-antiferromagnetic layers 63, 64.

The synthetic antiferromagnet 62 comprises first and second ferromagnetic layers 65₁, 65₂ which are antiferromagnetically exchange-coupled through a thin, central non-magnetic layer 66.

One or both ferromagnetic regions 65₁, 65₂ may be a single magnetic layer, such as a layer of cobalt (Co) or other elemental ferromagnetic material or iron nickel (FeNi), cobalt iron boron (CoFeB) or another ferromagnetic alloy. One or both ferromagnetic regions 65₁, 65₂ may take the form of a magnetic multilayer, such as cobalt/nickel/cobalt (Co/Ni/Co) or cobalt/platinum/cobalt (Co/Pt/Co).

The central, non-magnetic layer 66 has a thickness, t_{coupling}, which is selected to exchange-couple the two ferromagnetic regions 65₁, 65₂ antiferromagnetically. In this example, orientations of magnetizations 67₁, 67₂ of the two ferromagnetic regions 65₁, 65₂ point in opposite directions, out-of-plane. The central, non-magnetic layer 66 may comprise ruthenium (Ru) and may have a thickness less than 1 nm, for example 0.8 nm.

The thickness of the magnetic layers 65₁, 65₂ forming the ferromagnetic regions may be adjusted to exhibit perpendicular-to-plane anisotropy. Switching of magnetizations 67₁, 67₂ which are orientated out-of-plane can occur by domain-wall propagation.

The locally broken inversion symmetries in the ferromagnetic regions can exist even if a multilayer system is, overall, inversion symmetric. For example, the synthetic antiferromagnetic multilayer stack comprising a layer 63 of platinum, a first ferromagnetic layer 65₁, a layer of ruthenium 66, a second ferromagnetic layer 65₂ and a layer of platinum 64 exhibits inversion symmetry if the first and second ferromagnetic layers 65₁, 65₂ are identical. However, a first multilayer component 68₁ comprising the layer of platinum, the first ferromagnetic layer, the layer of ruthenium and a second multilayer component 68₂ comprising the layer of ruthenium, the second ferromagnetic layer and the layer of platinum exhibit local inversion asymmetry and form inversion partners.

Referring to Figure 19a, a synthetic antiferromagnet 61_{A}' may comprise repeated units 69_{A} of synthetic antiferromagnetic multilayer stacks of a layer 63 of non-antiferromagnetic material (such as platinum), a first layer 65₁ of ferromagnetic material (such as cobalt), a coupling layer 66 (for example, a layer of ruthenium) and a second layer 65₂ of ferromagnetic material (such as cobalt), capped by a final layer 64 of non-antiferromagnetic material. The first and second layers 65₁, 65₂ of ferromagnetic material exhibit out-of-plane anisotropy.

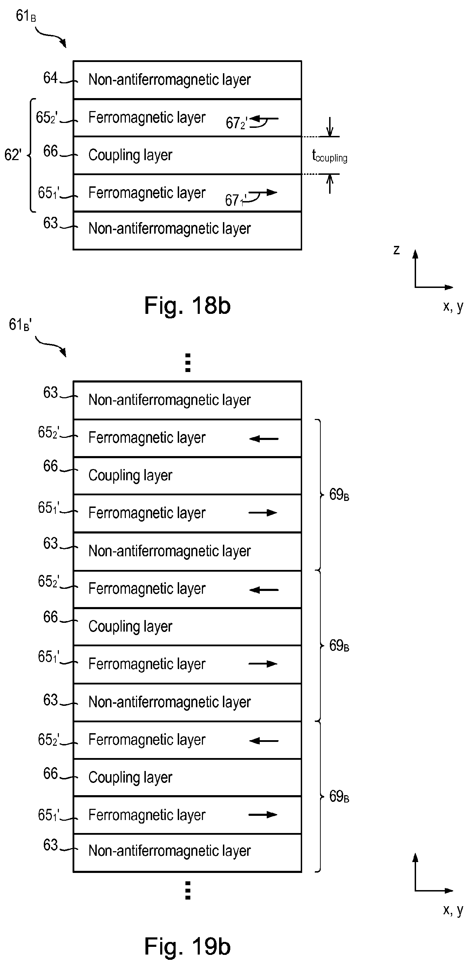

Referring to Figure 18b, a second layer structure 61_{B} is shown. The layer structure 61_{B} is the same as the first layer structure 61_{A} (Figure 18a) except that the thickness of magnetic layers 65₁', 65₂' forming the ferromagnetic regions is adjusted to exhibit in-plane anisotropy. Thus, magnetizations 67₁, 67₂ are oriented in plane.

Referring also to Figure 19b, a synthetic antiferromagnet 61B' may comprise repeated units 69B of synthetic antiferromagnetic multilayer stacks of a layer 63 of non-antiferromagnetic material (such as platinum), a first layer 65₁' of ferromagnetic material (such as cobalt), a coupling layer 66 (for example, a layer of ruthenium) and a second layer 65₂' of ferromagnetic material (such as cobalt), capped by a final layer 64 of non-antiferromagnetic material. The first and second layers 65₁', 65₂' of ferromagnetic material exhibit in-plane anisotropy.

### Non-volatile memory

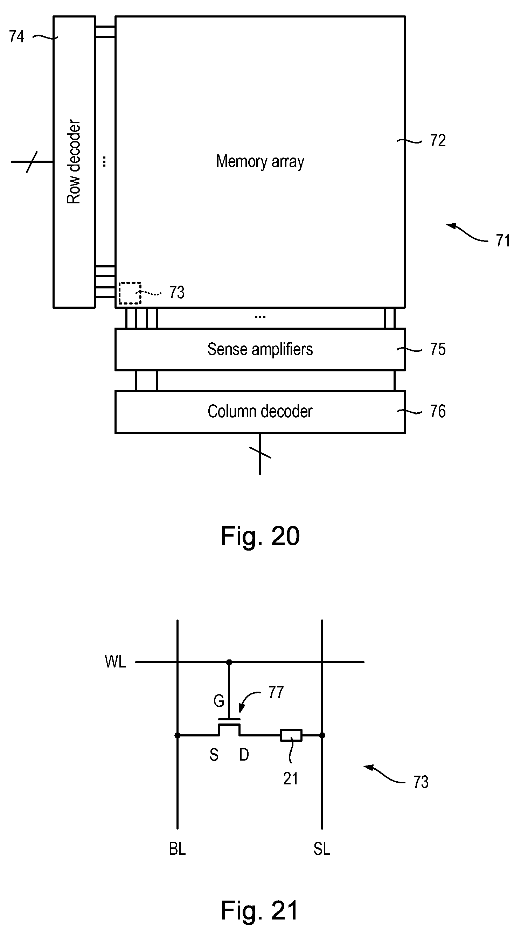

Referring to Figure 20, a non-volatile memory 71 is shown. The memory 71 includes an array 72 of cells 73, a row decoder 74, sense amplifiers 75 and a column decoder 76.

Referring also to Figure 21, each cell 73 is based on an antiferromagnetic memory device 21 hereinbefore described. The cell 73 includes a field-effect transistor 77. A word line WL is connected to the gate G of the transistor 77, a bit line BL is connected to the source S of the transistor 77 and the sense line SL is connect to one end of the memory device 21. The drain D of the transistor 77 is connected to the other terminal of the memory device 21.

### Modifications

It will be appreciated that many modifications may be made to the embodiments hereinbefore described.

The device need not be a lateral device. For example, the antiferromagnetic device may be a vertical device in which, for instance, the antiferromagnetic region may comprise a pillar-like region having lower and upper contacts.

## Claims

1. An antiferromagnetic memory device (21) comprising:
an antiferromagnetic region (24) exhibiting inversion asymmetry and having an easy axis (27); and
first and second contacts (25₁, 25₂) to the antiferromagnetic region which define a conductive path (33) in a first direction in which, when current flows along the conductive path, spin polarization is generated collinearly in a second direction which is orientated along the easy axis or at an angle which is equal to or less than 90° from the easy axis, wherein the antiferromagnetic memory device is a two-terminal device.

2. An antiferromagnetic memory device according to claim 1, wherein the antiferromagnetic region (24) comprises an antiferromagnetic material exhibiting inversion asymmetry of the spin-sublattices or be configured to exhibit inversion asymmetry of the spin-sublattices.

3. An antiferromagnetic memory device according to claim 1 or 2, wherein the antiferromagnetic region (24) is configured so as to exhibit structural inversion asymmetry.

4. An antiferromagnetic memory device according to any one of claims 1 to 3, wherein the antiferromagnetic region (24) comprises an antiferromagnetic material exhibiting bulk inversion asymmetry.

5. An antiferromagnetic memory device according to any one of claims 1 to 4, wherein the device comprises:
a multilayer structure (52₁, 52₂) comprising at least two layers;
wherein the multilayer structure includes:
a layer (24) of antiferromagnetic material providing the antiferromagnetic region (24) and
at least one layer (53, 55) of non-antiferromagnetic material directly in contact with the layer of antiferromagnetic material.

6. An antiferromagnetic memory device according to claim 5, wherein the multilayer structure includes:
a layer of first non-antiferromagnetic material;
a layer of second non-antiferromagnetic material;
wherein the antiferromagnetic material is interposed between the first and second non-antiferromagnetic material layers and the antiferromagnetic material is directly in contact with the layers of first and second non-antiferromagnetic materials.

7. An antiferromagnetic memory device according to claim 5 or 6, wherein the antiferromagnetic material is a metal or metal alloy.

8. An antiferromagnetic memory device according to claim 5 or 6, wherein the antiferromagnetic material is a semiconductor or an insulator.

9. An antiferromagnetic memory device according to any one of claims 5 to 8, wherein the first and/or second non-antiferromagnetic material is/are a transition metal or a transition metal alloy.

10. An antiferromagnetic memory device according to any one of claims 5 to 8, wherein the first and/or second non-antiferromagnetic material is/are a topological insulator or wherein the first and/or second non-antiferromagnetic material is/are an electrical insulator.

11. An antiferromagnetic memory device according to any one of claims 1 to 10, wherein the antiferromagnetic region comprises a synthetic antiferromagnet comprising:
first and second oppositely-polarised ferromagnetic regions;
a non-magnetic region interposed between and directly in contact with the ferromagnetic regions.

12. An antiferromagnetic memory device according to any one of claims 1 to 11, wherein the antiferromagnetic region exhibits multiaxial magnetic anisotropy.

13. An antiferromagnetic memory device according to any one of claims 1 to 12, wherein the antiferromagnetic region is under strain.

14. Apparatus comprising:
an antiferromagnetic memory device (21) according to any preceding claim;
a write circuit configured to apply a bias between the first and second contacts so as to drive a current having a sufficiently large current density so as to generate sufficiently large spin polarization so as to cause sublattice magnetization to reorient by 180°; and
a read circuit configured to apply a bias between the first and second contacts so as determine resistance of the antiferromagnetic region.

15. A method of operating an antiferromagnetic memory device according to any one of claims 1 to 13, the method comprising:
programming the device by driving a current along the conductive path (33) having a sufficiently large current density so as to generate sufficiently large spin polarization so as to cause sublattice magnetization in the antiferromagnetic region to reorient by 180°.

16. A method of operating an antiferromagnetic memory device according to claim 15, the method comprising:
reading the device by driving a current along the conductive path (33) having a current density that does not cause sublattice magnetization in the antiferromagnetic region to reorient by 180°.

## Amended claims

### Amended claims in accordance with Rule 137(2) EPC.

1. A memory device (21) comprising:
a planar antiferromagnetic region (24) having an in-plane easy axis (27), the antiferromagnetic region:
(i) comprises an antiferromagnetic material exhibiting inversion asymmetry;
(ii) comprises an antiferromagnetic material exhibiting inversion asymmetry of spin sub-lattices;
(iii) comprised in a multilayer comprising having structural inversion asymmetry; or
(iv) comprised in a multilayer structure (52₁, 52₂) comprising at least two layers, the multilayer structure comprising a layer (24) of antiferromagnetic material providing the antiferromagnetic region (24) and at least one layer (53, 55) of non-antiferromagnetic material directly in contact with the layer of antiferromagnetic material; and
first and second contacts (25₁, 25₂) to the antiferromagnetic region which define an in-plane conductive path (33) in a first direction wherein, when current flows along the conductive path, spin polarization is generated collinearly in a second direction which is orientated along the easy axis or at an angle which is less than 90° from the easy axis, wherein the antiferromagnetic memory device is a two-terminal device.

2. A memory device according to claim 1, wherein the multilayer structure includes:
a layer of first non-antiferromagnetic material;
a layer of second non-antiferromagnetic material;
wherein the antiferromagnetic material is interposed between the first and second non-antiferromagnetic material layers and the antiferromagnetic material is directly in contact with the layers of first and second non-antiferromagnetic materials.

3. A memory device according to claim 1 or 2, wherein the antiferromagnetic material is a metal or metal alloy.

4. A memory device according to claim 1 or2, wherein the antiferromagnetic material is a semiconductor or an insulator.

5. A memory device according to any one of claims 1 to 4, wherein the first and/or second non-antiferromagnetic material is/ are a transition metal or a transition metal alloy.

6. A memory device according to any one of claims 1 to 4, wherein the first and/or second non-antiferromagnetic material is/ are a topological insulator or wherein the first and/or second non-antiferromagnetic material is/are an electrical insulator.

7. A memory device according to any one of claims 1 to 6, wherein the antiferromagnetic region comprises a synthetic antiferromagnet comprising:
first and second oppositely-polarised ferromagnetic regions;
a non-magnetic region interposed between and directly in contact with the ferromagnetic regions.

8. A memory device according to any one of claims 1 to 7, wherein the antiferromagnetic region exhibits multiaxial magnetic anisotropy.

9. A memory device according to any one of claims 1 to 8, wherein the antiferromagnetic region is under strain.

10. Apparatus comprising:
a memory device (21) according to any preceding claim;
a write circuit configured to apply a bias between the first and second contacts so as to drive a current having a sufficiently large current density so as to generate sufficiently large spin polarization so as to cause sublattice magnetization to reorient by 180°; and
a read circuit configured to apply a bias between the first and second contacts so as determine resistance of the antiferromagnetic region.

11. A method of operating a memory device according to any one of claims 1 to 9, the method comprising:
programming the device by driving a current along the conductive path (33) having a sufficiently large current density so as to generate sufficiently large spin polarization so as to cause sublattice magnetization in the antiferromagnetic region to reorient by 180°.

12. A method of operating a memory device according to claim 11, the method comprising:
reading the device by driving a current along the conductive path (33) having a current density that does not cause sublattice magnetization in the antiferromagnetic region to reorient by 180°.
